# EUROPÄISCHE PATENTSCHRIFT

(11) **EP 2 227 929 B1**
(45) Veröffentlichungstag und Bekanntmachung des Hinweises auf die Patenterteilung: **13.03.2013**
(21) Anmeldenummer: 08866233.3
(22) Anmeldetag: 06.11.2008
(51) Int. Cl.: H05K 5/06, H05K 7/20

(54) **ELEKTRONIKEINHEIT MIT EINEM GEHÄUSE**
ELECTRONIC UNIT WITH A HOUSING
UNITÉ ÉLECTRONIQUE AVEC UN BOÎTIER

(30) Priorität: 28.12.2007 DE 102007063310
(43) Veröffentlichungstag der Anmeldung: 15.09.2010
(73) Patentinhaber: Robert Bosch GmbH, 70442 Stuttgart (DE)
(72) Erfinder: SINGLE, Ulrich, 11900 Penang (MY)
(86) Internationale Anmeldenummer: PCT/EP2008/065061
(87) Internationale Veröffentlichungsnummer: WO 2009/083315

(56) Entgegenhaltungen:
- EP-A- 0 489 341
- DE-A1- 2 710 211
- US-A- 4 471 407
- US-A1- 2007 079 980

## Beschreibung

### Technisches Gebiet

Die Erfindung betrifft eine Elektronikeinheit mit einem Gehäuse insbesondere für Einsatz in Elektrogeräten.

### Stand der Technik

Bei modernen Elektrogeräten oder Elektrowerkzeugen wird häufig eine Leistungselektronik verwendet, um eine Regelung wie z.B. eine Drehzahlregelung, eine Leistungssteuerung, Schutzfunktionen oder Zusatzfunktionen zu realisieren. Da insbesondere Elektrowerkzeuge kompakt gestaltet sein müssen und unter rauen Umgebungsbedingungen eingesetzt werden, sollte die Elektronikeinheit möglichst geringe Abmessungen aufweisen und zudem vor Umgebungseinflüssen ausreichend geschützt sein. Ferner ist es notwendig, insbesondere bei einer Leistungselektronik eine ausreichende Wärmeabfuhr zu gewährleisten. Weiterhin ist es wünschenswert, die Elektronik vor EMV-Einflüssen zu schützen, da diese häufig in der Umgebung von Quellen von EMV-Störungen, wie z.B. einem Elektromotor, eingesetzt werden.

Das Dokument US4,471,407 offenbart eine Elektronikeinheit mit einem Becherelement, dessen offene Oberseite teilweise von einem Kühlkörper abgedeckt wird.

Das Dokument EP0489341A1 offenbart eine Elektronikeinheit für ein Elektrowerkzeug mit einem Becherförmigen Gehäuse und einem eine Gehäuseöffnung abdeckenden Kühlkörper.

Das Dokument US2007/0079980A1 offenbart eine Elektronikeinheit für ein Elektrowerkzeug mit einem geschlossenen Gehäuse, wobei ein Teil des Gehäuses von einem Kühlkörper gebildet wird.

Es ist daher Aufgabe der vorliegenden Erfindung, ein verbessertes Gehäuse zur Verfügung zu stellen, das kompakt ist, eine ausreichende Wärmeabführung ermöglicht, einfach aufgebaut werden kann und gegen Umwelteinflüsse ausreichend geschützt ist.

### Offenbarung der Erfindung

Diese Aufgabe wird durch das Gehäuse gemäß Anspruch 1 gelöst.

Weitere vorteilhafte Ausgestaltungen der Erfindung sind in den abhängigen Ansprüchen angegeben.

Gemäß einem Aspekt ist eine Elektronikeinheit zum Einsatz in einem Elektrowerkzeug vorgesehen. Die Elektronikeinheit umfasst:
- ein Becherelement mit einem Bodenteil und Seitenteilen, wobei das Becherelement zu einer dem Bodenteil gegenüber liegenden Seite hin offen und an;
- ein u-förmiges Kühlelement mit einem Deckelteil und Schenkelteile;
- eine Leiterplatte, die in dem Becherelement angeordnet ist und über ein Befestigungselement an dem Kühlelement fixiert ist;
wobei das u-förmige Kühlelement so auf das Becherelement aufgesetzt ist, dass eine dem Bodenteil gegenüber liegende Öffnung des Becherelementes von dem Deckelteil des Kühlelements abgedeckt wird, so dass ein Abschnitt der Öffnung des Becherelements unbedeckt verbleib und die Schenkelteile des Külelements das Becherelement derart umschließen, dass dessen Seitenteile teilweise von den Schenkelteilen des Kühlelements bedeckt sind und aneinander anliegen bzw. einen sehr geringen Abstand zueinander aufweisen.

Weiterhin kann der Innenraum des Becherelements mit einem Vergussmaterial gefüllt sein, um Bauelemente auf der Leiterplatte zu versiegeln.

Gemäß einer Ausführungsform kann eine dem Abschnitt der Öffnung gegenüber liegendes Ende des Kühlelements mit einem Seitenteil des Becherelements bündig abschließen.

Weiterhin kann ein Seitenteil des Becherelements ein Anschlagselement aufweisen, das an dem dem Abschnitt der Öffnung gegenüber liegenden Ende des Kühlelements anliegt und insbesondere als verlängertes Seitenteil ausgebildet ist. Gemäß einer Ausführungsform kann die Leiterplatte ein Leistungshalbleiterbauelement aufweisen, das über das Befestigungselement mit dem Kühlelement für eine Wärmeableitung gekoppelt ist.

Das Becherelement und das Kühlelement können über ein Rastelement miteinander fixierbar sein.

Zum Anschließen der elektronischen Schaltung auf der Leiterplatte kann eine Anschlussleitung der Leiterplatte durch den Abschnitt der Öffnung des Becherelements geführt sein.

Weiterhin kann eine Anschlussleitung der Leiterplatte durch den Abschnitt der Öffnung des Becherelements geführt sein.

### Kurzbeschreibung der Zeichnungen

Bevorzugte Ausführungsformen der Erfindung werden nachfolgend anhand der beigefügten Zeichnungen näher erläutert. Es zeigen:
Fig. 1 eine perspektivische Darstellung einer Elektronikeinheit gemäß einer Ausführungsform der Erfindung;
Fig. 2 eine weitere perspektivische Darstellung der Elektronikeinheit ohne Zuleitungen gemäß der Ausführungsform der Fig.1;
Fig. 3 eine Draufsicht auf die Elektronikeinheit der Ausführungsform der Fig. 1;
Fig. 4 eine Vorderansicht auf die Elektronikeinheit der Ausführungsform der Fig. 1;
Fig. 5 eine Schnittdarstellung durch die Elektronikeinheit der Ausführungsform der

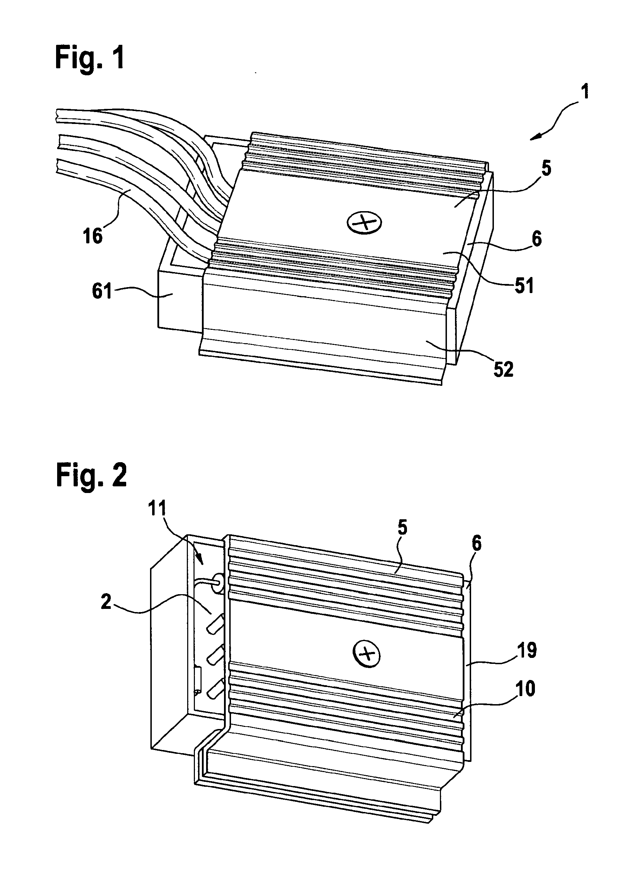

Fig. 1 ohne Darstellung des Vergußbechers;

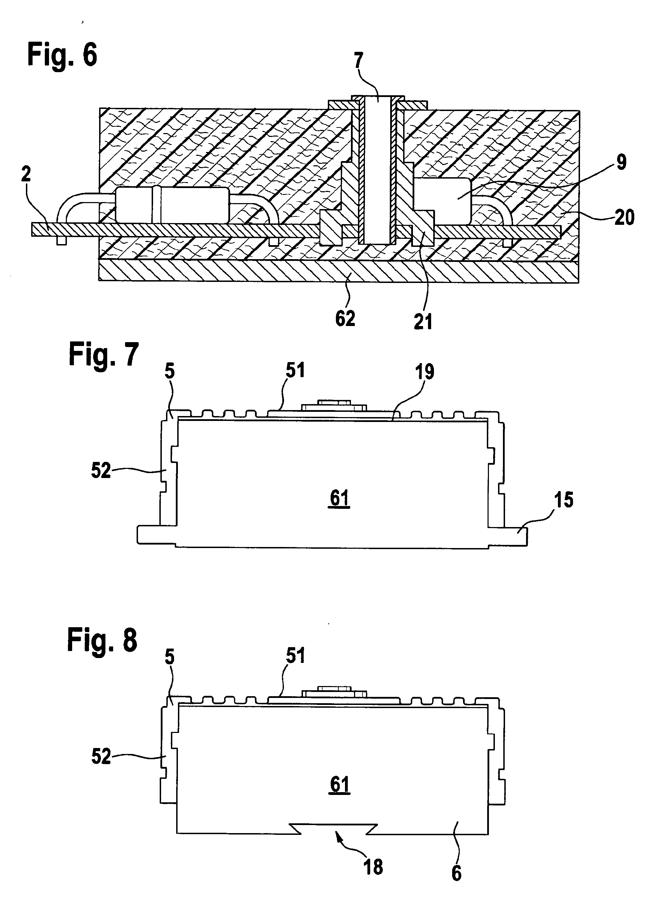

Fig. 6 eine weitere Schnittdarstellung durch die Elektronikeinheit der Ausführungsform der Fig. 1 in Längsrichtung;
Fig. 7 eine Seitendarstellung der Elektronikeinheit in einer weiteren Ausführungsform; und
Fig. 8 eine Seitendarstellung der Elektronikeinheit in einer weiteren Ausführungsform.

### Beschreibung der Ausführungsformen

Die Erfindung wird im Folgenden anhand der Figuren 1 bis 7, die verschiedene Darstellungen der Elektronikeinheit gemäß einer Ausführungsform der Erfindung darstellen, ausführlich beschrieben. Die Elektronikeinheit 1 umfasst ein Gehäuse und eine darin aufgenommene Leiterplatte 2. Die Leiterplatte 2 ist mit elektronischen Bauelementen 9, beispielsweise mit konventionellen Bauelementen oder SMD-Bauelementen, bestückt. Die Leiterplatte 2 kann einen Leistungshalbleiter 3, wie z.B. einen FET umfassen, der mit einem Wärmeableitungsteil 4 versehen ist. Das Wärmeableitungsteil 4 des Leistungshalbleiters 3 kann zur Wärmeableitung in geeigneter Weise mit einem Kühlkörper 5 gekoppelt werden.

Der Kühlkörper 5 ist im Wesentlichen U-förmig mit einem Deckelteil 51 und Schenkelteilen 52 ausgebildet. Der Kühlkörper 5 kann beispielsweise als Strangpressprofil, Stanzbiegeteil oder im einfachsten Fall als flaches Aluminium- oder Kupferteil ausgeführt werden. Zwischen den Schenkelteilen 52 ist ein Vergussbecher 6 mit Seitenteilen 61 und einem Bodenteil 62 aufgenommen, so dass die dem Bodenteil 62 gegenüberliegende Öffnung des Vergussbechers 6 zumindest teilweise von dem Deckelteil 51 des Kühlkörpers 5 abgedeckt wird. Die Schenkelteile 52 des Kühlkörpers 5 umschließen dabei den Vergussbecher 6, so dass deren Seitenteile teilweise von den Schenkelteilen 52 des Kühlkörpers 5 bedeckt sind und aneinander anliegen bzw. einen sehr geringen Abstand zueinander aufweisen.

Die Leiterplatte 2 ist im montierten Zustand in dem Vergussbecher 6 aufgenommen und an dem Kühlkörper 5 befestigt. Dazu ist der Kühlkörper 5 mit einer Öffnung versehen, durch die ein Befestigungselement 7, wie z.B. eine Schraube oder eine Niete, geführt werden kann. Zwischen dem Kühlkörper 5 und der Leiterplatte 2 ist ein Halteteil 21 vorgesehen, dass den Kühlkörper 5 und die Leiterplatte 2 voneinander beabstandet und in der gewünschten Ausrichtung hält. Vorzugsweise wird die Leiterplatte 2 parallel zu dem Deckelteil 51 des Kühlkörpers 5 fixiert. Gleichzeitig kann das Befestigungselement 7 dazu dienen, das Wärmeableitungsblech 4 des Leistungshalbleiters 3 mit dem Kühlkörper 5 für eine optimale Wärmeabführung zu koppeln. Der Kühlkörper 5 weist Kühllamellen 10 vorzugsweise an seinem Deckelteil 51 auf. Zwischen dem Wärmeableitungsblech 4 und dem Kühlkörper 5 kann eine Isolierung 8 vorgesehen sein, die z.B. als Glimmerscheibe und dgl. ausgelegt ist, um den Leistungshalbleiter 3 vom Kühlkörper 5 elektrisch zu isolieren.

Der Vergussbecher 6 weist vorzugsweise Abmessungen auf, die etwas größer sind als der Kühlkörper 5, so dass bei auf den Vergussbecher 6 aufgesetztem Kühlkörper 5 die Öffnung des Vergussbechers 6 nicht vollständig abgedeckt wird. Durch die verbleibende Öffnung 11 ist der Innenraum des Vergussbechers 6 zugänglich und es können beispielsweise Anschlusskabel 16 durch diese Öffnung 11 geführt werden. Die Öffnung 11 ist weiterhin geeignet, um ein aushärtbares, fließfähiges Vergussmaterial 20 in den Innenraum des durch Kühlkörper 5 und Vergussbecher 6 gebildeten Gehäuses einzugeben, so dass die elektronischen Bauelemente der Leiterplatte 2 versiegelt werden können und so gegen Umgebungseinflüsse, insbesondere gegen Staub und Schmutz, geschützt sind. Somit können die Bauelemente 9 bzw. die Schaltung auf der Leiterplatte 2 nicht mehr durch Verschmutzung und dergleichen beschädigt oder zerstört werden.

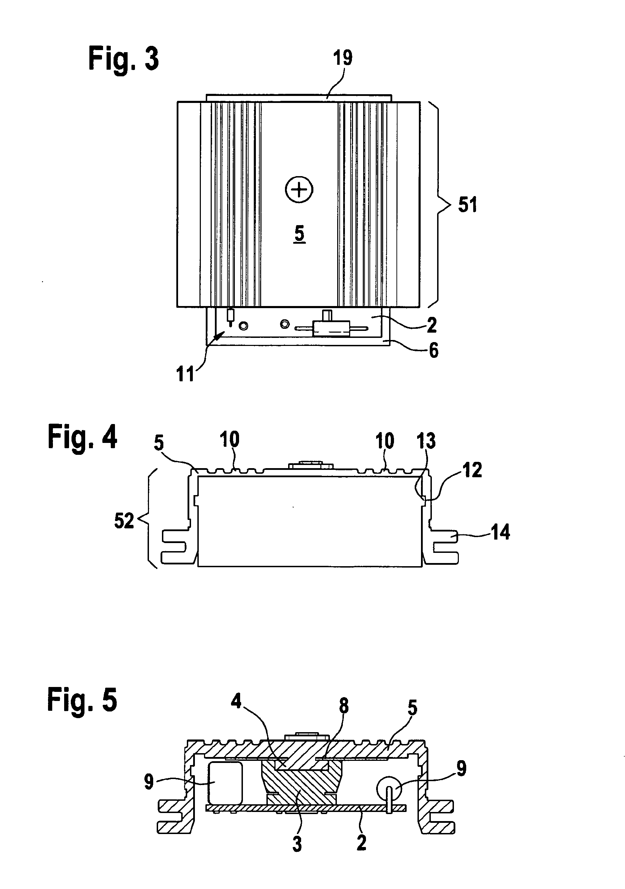

Ferner können der Vergussbecher 6 und der Kühlkörper 5 in geeigneter Weise mit Rastelementen 12, 13 versehen sein, die bei Aufeinandersetzen von Vergussbecher 6 und Kühlkörper 5 so miteinander verrasten, dass der Vergussbecher 6 an dem Kühlkörper 5 zumindest in Richtung senkrecht zur Ausdehnung des Decketeils 51 des Kühlkörpers 5 gehalten wird. Die Rastelemente 12, 13 können beispielsweise in dem Kühlkörper 5 als Ausnehmungen bzw. Schlitze 12 in den Schenkelteilen 52 und an den Seitenteilen 61 des Vergussbecher 6 als hervorstehende Nasen 13 ausgebildet sein. (siehe Fig. 4).

Der Kühlkörper 5 kann mit einer Führung 14 an einem oder beiden Schenkeln ausgebildet sein, um das Gehäuse 1 in einem Elektrogerät zu befestigen (siehe Figs. 4 und 5). Als Alternative kann der Vergussbecher 6 mit Führungselementen 15 versehen sein, die von Seitenteilen 61 des Vergussbechers 6 abstehen und vorzugsweise eine Verlängerung des Bodenteils 62 des Vergussbechers 6 darstellen (Fig. 7). Wie in Fig. 8 gezeigt ist, kann weiterhin die Führung z.B. in Form einer Schwalbenschwanzführung 18 im Bodenteil 62 des Vergussbechers 6 ausgeführt werden, so dass das gesamte Gehäuse in einfacher Weise durch Aufschieben in dem Elektrogerät eingesetzt und befestigt werden kann. Auf diese Weise erhält man eine Elektronikeinheit, die durch ein Gehäuse mit sehr geringen Abmessungen geschützt ist und mit einer für die geringen Abmessungen sehr großen Kühlkörperoberfläche bei gleichzeitig einfachem Aufbau aufweist.

Der Vergussbecher 6 kann weiterhin mit einer oder mehreren überstehenden Lippen 19 ausgestattet werden. Die Lippe 19 dient dazu, um z.B. ein Auslaufen der Vergussmaterials 20 im flüssigen Zustand aus dem Innenraum des Gehäuses zu verhindern. Eine der Lippen 19 ist vorzugsweise an dem Seitenteil 62 des Vergussbechers 6 angeordnet, die der Öffnung 11 durch die das Vergussmaterial 20 eingefüllt wird, gegenüberliegt. Die Lippe 19 ist beispielsweise in Form einer erhöhten Seitenteils 62 des Vergussbechers 6 ausgebildet und bildet somit gleichzeitig einen Anschlag an ein Ende des Kühlkörpers 5, um eine exakte Positionierung des Vergussbechers 6 an dem Kühlkörper 5 in Richtung parallel zur Längsrichtung der Schenkelteile 52 des Kühlkörpers 5 zu ermöglichen.

## Patentansprüche

1. Elektronikeinheit (1) zum Einsatz in einem Elektrowerkzeug, umfassend:
- ein Becherelement (6) mit einem Bodenteil (62) und Seitenteilen (61), wobei das Becherelement (6) zu einer dem Bodenteil (62) gegenüber liegenden Seite hin offen und an den Seiten geschlossen ist;
- ein u-förmiges Kühlelement (5) mit einem Deckelteil (51) und Schenkelteilen (52);
- eine Leiterplatte (2), die in dem Becherelement (6) angeordnet ist und über ein Befestigungselement an dem Kühlelement (5) fixiert ist; wobei das u-förmige Kühlelement (5) so auf das Becherelement (6) aufgesetzt ist, dass die dem Bodenteil (62) gegenüber liegende Öffnung des Becherelementes (6) von dem Deckelteil (51) des Kühlelements (5) abgedeckt wird, so dass ein Abschnitt der Öffnung des Becherelements (6) unbedeckt verbleibt, und die Schenkelteile (52) des Kühlelements (5) das Becherelement (6) derart umschließen, dass dessen Seitenteile (61) teilweise von den Schenkelteilen (52) des Kühlelements (5) bedeckt sind
und aneinander anliegen bzw. einen sehr geringen Abstand zueinander aufweisen.

2. Elektronikeinheit (1) nach Anspruch 1, wobei der Innenraum des Becherelements (6) mit einem Vergussmaterial gefüllt ist, um Bauelemente auf der Leiterplatte (2) zu versiegeln.

3. Elektronikeinheit (1) nach Anspruch 1 oder 2, wobei eine dem Abschnitt der Öffnung gegenüber liegendes Ende des Kühlelements (5) mit einem Seitenteil des Becherelements (6) bündig abschließt.

4. Elektronikeinheit (1) nach Anspruch 3, wobei ein Seitenteil des Becherelements ein Anschlagselement (19) aufweist, das an dem dem Abschnitt der Öffnung gegenüber liegenden Ende des Kühlelements (5) anliegt und insbesondere als verlängertes Seitenteil ausgebildet ist.

5. Elektronikeinheit (1) nach einem der Ansprüche 1 bis 4, wobei die Leiterplatte (2) ein Leistungshalbleiterbauelement (3) aufweist, das über das Befestigungselement mit dem Kühlelement (5) für eine Wärmeableitung gekoppelt ist.

6. Elektronikeinheit (1) nach einem der Ansprüche 1 bis 5, wobei das Becherelement (6) und das Kühlelement (5) über ein jeweiliges Rastelement (12, 13) miteinander fixierbar sind.

7. Elektronikeinheit (1) nach einem der Ansprüche 1 bis 6, wobei eine Anschlussleitung (16) der Leiterplatte (2) durch den Abschnitt der Öffnung des Becherelements (6) geführt ist.

## Claims

1. Electronics unit (1) for insertion into an electric tool, comprising:
- a cup element (6) having a base part (62) and side parts (61), wherein the cup element (6) is open in the direction of a side which is opposite the base part (62) and is closed at the sides;
- a u-shaped cooling element (5) having a cover part (51) and limb parts (52);
- a printed circuit board (2) which is arranged in the cup element (6) and is fixed to the cooling element (5) by means of a fastening elements; wherein the u-shaped cooling element (5) is mounted on the cup element (6) such that the opening in the cup element (6), which opening is opposite the base part (62), is covered by the cover part (51) of the cooling element (5), and therefore a portion of the opening in the cup element (6) remains uncovered, and the limb parts (52) of the cooling element (5) surround the cup element (6) in such a way that the side parts (61) of the said cup element are partially covered by the limb parts (52) of the cooling element (5) and rest against one another or are at a very short distance from one another.

2. Electronics unit (1) according to Claim 1, wherein the interior space in the cup element (6) is filled with an encapsulation material in order to seal components on the printed circuit board (2).

3. Electronics unit (1) according to Claim 1 or 2, wherein an end of the cooling element (5), which end is opposite the portion of the opening, terminates flush with a side part of the cup element (6).

4. Electronics unit (1) according to Claim 3, wherein a side part of the cup element has a stop element (19) which rests against that end of the cooling element (5) that is opposite the portion of the opening, and which is, in particular, in the form of an extended side part.

5. Electronics unit (1) according to one of Claims 1 to 4, wherein the printed circuit board (2) has a power semiconductor component (3) which is coupled to the cooling element (5) by means of the fastening element for the purpose of dissipating heat.

6. Electronics unit (1) according to one of Claims 1 to 5, wherein the cup element (6) and the cooling element (5) can be fixed to one another by means of a respective latching element (12, 13).

7. Electronics unit (1) according to one of Claims 1 to 6, wherein a connection line (16) of the printed circuit board (2) is routed through the portion of the opening in the cup element (6).

## Revendications

1. Unité électronique (1) pouvant être utilisée dans un outil électrique, comprenant :
- un élément en bécher (6) avec une partie de fond (62) et des parties latérales (61), l'élément en bécher (6) étant ouvert en direction d'un côté opposé à la partie de fond (62) et fermé au niveau des côtés ;
- un élément de refroidissement (5) en forme de U avec une partie de couvercle (51) et des parties de flanc (52) ;
- une plaque conductrice (2) disposée dans l'élément en bécher (6) et fixée à l'élément de refroidissement (5) par le biais d'un élément de fixation ; l'élément de refroidissement (5) en forme de U étant placé de telle sorte sur l'élément en bécher (6) que l'ouverture de l'élément en bécher (6), opposée à la partie de fond (62), est recouverte par la partie de couvercle (51) de l'élément de refroidissement (5), de sorte qu'une section de l'ouverture de l'élément en bécher (6) reste non recouverte et que les parties de flanc (52) de l'élément de refroidissement (5) entourent de telle sorte l'élément en bécher (6) que leurs parties latérales (61) sont en partie recouvertes par les parties de flanc (52) de l'élément de refroidissement (5) et reposent les unes contre les autres et/ou présentent un l'écartement très réduit les unes par rapport aux autres.

2. Unité électronique (1) selon la revendication 1, l'espace intérieur de l'élément en bécher (6) étant rempli d'un matériau de scellement permettant de sceller les composants sur la plaque conductrice (2).

3. Unité électronique (1) selon la revendication 1 ou 2, une extrémité, opposée à la section de l'ouverture, de l'élément de refroidissement (5) se terminant en affleurement par une partie latérale de l'élément en bécher (6).

4. Unité électronique (1) selon la revendication 3, une partie latérale de l'élément en bécher comportant un élément de butée (19) butant contre l'extrémité, opposée à la section de l'ouverture, de l'élément de refroidissement (5) et prenant notamment la forme d'une partie latérale rallongée.

5. Unité électronique (1) selon l'une quelconque des revendications 1 à 4, la plaque conductrice (2) comportant un composant semi-conducteur de puissance (3) couplé à l'élément de refroidissement (5) par le biais de l'élément de fixation pour évacuer la chaleur.

6. Unité électronique (1) selon l'une quelconque des revendications 1 à 5, l'élément en bécher (6) et l'élément de refroidissement (5) pouvant être fixés entre eux par le biais d'un élément d'encliquetage (12, 13) respectif.

7. Unité électronique (1) selon l'une quelconque des revendications 1 à 6, un câble de raccordement (16) de la plaque conductrice (2) étant guidé à travers la section de l'ouverture de l'élément en bécher (6).
